(19) Europäisches Patentamt
European Patent Office
Office européen des brevets

(11) **EP 4 421 500 B1**

(12) **EUROPEAN PATENT SPECIFICATION**

(45) Date of publication and mention
of the grant of the patent:
**03.09.2025 Bulletin 2025/36**

(21) Application number: **24152967.6**

(22) Date of filing: **19.01.2024**

(51) International Patent Classification (IPC):
**G01R 19/00** *(2006.01)*　　　**G01R 31/42** *(2006.01)*
**H02M 1/00** *(2006.01)*

(52) Cooperative Patent Classification (CPC):
**H02M 1/0009; G01R 19/0092; G01R 31/42**

(54) **ESTIMATION SYSTEM**

SCHÄTZSYSTEM

SYSTÈME D'ESTIMATION

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **21.02.2023　JP 2023025017**

(43) Date of publication of application:
**28.08.2024　Bulletin 2024/35**

(73) Proprietor: **TOYOTA JIDOSHA KABUSHIKI
KAISHA**
**Toyota-shi, Aichi-ken, 471-8571 (JP)**

(72) Inventors:
• **ASANO, Yuko**
**Toyota-shi, 471-8571 (JP)**
• **TANABE, Yukinari**
**Toyota-shi, 471-8571 (JP)**

(74) Representative: **D Young & Co LLP**
**3 Noble Street**
**London EC2V 7BQ (GB)**

(56) References cited:
**CN-A- 101 227 168　　JP-A- 2006 020 401
US-A1- 2009 058 334　　US-A1- 2010 295 492**

**Description**

CROSS REFERENCE TO RELATED APPLICATIONS

This nonprovisional application is based on Japanese Patent Application No. 2023-025017 filed with the Japan Patent Office on February 21, 2023.

BACKGROUND

Field

The present disclosure relates to an estimation system and particularly to an estimation system that estimates a current value of a power storage device.

Description of the Background Art

Japanese Patent Laying-Open No. 2006-20401 discloses a battery management system. This system includes a battery (power storage device), a three-phase alternating-current (AC) motor, a large number of sensors, and a control unit. Each sensor detects a corresponding physical quantity such as an accelerator positon, a vehicle speed, the number of rotations of the three-phase AC motor, and a voltage across terminals of the battery. The control unit calculates an estimated value of a battery current in accordance with detection values of these physical quantities.

SUMMARY

The detection value from each sensor may include such an error as an offset error and a gain error. When the estimated value is calculated from a large number of detection values as above, this estimated value is affected by a large number of errors included in the large number of respective detection values, which results in lowering in accuracy of the estimated value.
The present disclosure was made to solve the problem as above, and an object thereof is to provide an estimation system that accurately estimates a current value of a power storage device.
An estimation system in the present disclosure includes a power storage device, a first three-phase inverter, and a first three-phase AC motor. The first three-phase inverter is connected to the power storage device, and includes a first leg circuit, a second leg circuit, and a third leg circuit. The first three-phase AC motor is connected to the first three-phase inverter. Each of the first leg circuit, the second leg circuit, and the third leg circuit includes an upper arm circuit and a lower arm circuit that is turned on and off in a manner complementary to the upper arm circuit. A mode of the first three-phase inverter includes a first mode in which the upper arm circuit of the first leg circuit, the lower arm circuit of the second leg circuit, and the lower arm circuit of the third leg circuit are on and a second mode in which the lower arm circuit of the first leg circuit, the upper arm circuit of the second leg circuit, and the upper arm circuit of the third leg circuit are on. The estimation system further includes a first current sensor and a processing device. The first current sensor detects an AC current that flows between a first-phase coil of the first three-phase AC motor and the first leg circuit. The processing device performs estimation processing for estimating a current value of the power storage device. The estimation processing includes first processing for estimating the current value in accordance with a detection value from the first current sensor when the mode of the first three-phase inverter is set to the first mode or the second mode.
When the mode of the inverter is set to the first mode, a first closed-loop circuit composed of the upper arm circuit of the first leg circuit, a neutral point of the first three-phase AC motor, the lower arm circuit of the second leg circuit and the lower arm circuit of the third leg circuit, and the power storage device is formed. Similarly, when the mode of the inverter is set to the second mode, a second closed-loop circuit composed of the lower arm circuit of the first leg circuit, the neutral point of the first three-phase AC motor, the upper arm circuit of the second leg circuit and the upper arm circuit of the third leg circuit, and the power storage device is formed. According to the configuration, on the assumption that the detection value from the first current sensor is equal to the current value of the power storage device in the first closed-loop circuit or the second closed-loop circuit, this current value is estimated. Thus, in order to estimate the current value, only the detection value from the first current sensor suffices and the detection values from a large number of sensors are not required. Consequently, such a situation as lowering in accuracy in estimation of the current value due to use of detection values from a large number of sensors can be avoided. Therefore, the current value of the power storage device can accurately be estimated.
Preferably, the first processing includes processing for estimating the current value in accordance with a peak value of the detection value from the first current sensor.
Preferably, the estimation system further includes a second current sensor that detects an AC current that flows between a second-phase coil of the first three-phase AC motor and the second leg circuit. The mode of the first three-phase inverter includes a third mode in which the lower arm circuit of the first leg circuit, the upper arm circuit of the second leg circuit, and the lower arm circuit of the third leg circuit are on and a fourth mode in which the upper arm circuit of the first leg circuit, the lower arm circuit of the second leg circuit, and the upper arm circuit of the third leg circuit are on. The estimation processing further includes second processing for estimating the current value in accordance with a detection value from the second current sensor when the mode of the first three-phase inverter is set to the third mode or the fourth mode.

Preferably, the second processing includes processing for estimating the current value in accordance with a peak value of the detection value from the second current sensor after the first current sensor detects the peak value.

The first processing and the second processing are performed every one cycle of an AC current (first AC current) that flows through a first phase of the first three-phase AC motor and an AC current (second AC current) that flows through a second phase thereof. The current value is thus determined not only every one cycle of the first AC current but also every one cycle of the second AC current. Consequently, the processing device can use as the estimated value of the current value, peak values more than in an example where only the first processing is performed. The processing device can confirm that neither of the first current sensor and the second current sensor has failed, for example, based on the fact that a difference between a maximum value and a minimum value of absolute values of these peak values is smaller than a prescribed minute value. The processing device can thus confirm high reliability of the estimated value based on the detection values from the first current sensor and the second current sensor.

Preferably, the estimation system further includes at least one electrical apparatus each configured to be activated by receiving electric power from the power storage device. The processing device performs the first processing while the at least one electrical apparatus is inactive.

When the at least one electrical apparatus is activated, electric power is supplied from the power storage device not only to the inverter but also to the at least one electrical apparatus (the current flows thereto). Consequently, the detection value from the first current sensor is not necessarily equal to the current value of the power storage device. According to the configuration, first estimation processing is performed while a current does not flow from the power storage device to the at least one electrical apparatus. Accuracy in estimation of the current value of the power storage device can thus further be improved.

Preferably, the at least one electrical apparatus includes auxiliary machinery configured to be activated at an output voltage from the power storage device, a power converter configured to lower the output voltage, and a second three-phase inverter connected in parallel to the first three-phase inverter with respect to the power storage device.

Preferably, the estimation system further includes a boost chopper circuit connected between the power storage device and the first three-phase inverter. The boost chopper circuit includes an upper arm circuit and a lower arm circuit. The processing device performs the first processing while a conducting state of the upper arm circuit of the boost chopper circuit and a non-conducting state of the lower arm circuit of the boost chopper circuit are maintained and a load of the first three-phase AC motor is constant.

While the conducting state of the upper arm circuit and the non-conducting state of the lower arm circuit are maintained and the load of the three-phase AC motor is constant, the current in the first closed-loop circuit or the second closed-loop circuit is not varied by a reactor of the boost chopper circuit. According to the configuration, even when a vehicle includes the boost chopper circuit, the current value of the power storage device can accurately be estimated in the first estimation processing.

Preferably, the estimation system further includes a current detector that detects the current value of the power storage device. The processing device is configured to further perform failure diagnosis processing for diagnosing whether the current detector has failed based on comparison between the detection value from the first current sensor and a detection value from the current detector.

According to the configuration, whether or not the current detector has failed can accurately be diagnosed.

The foregoing and other objects, features, aspects and advantages of this disclosure will become more apparent from the following detailed description of this disclosure when taken in conjunction with the accompanying drawings.

BRIEF DESCRIPTION OF THE DRAWINGS

Fig. 1 is a diagram of an overall configuration of a vehicle on which an estimation system according to an embodiment is mounted.
Fig. 2 is a diagram illustrating a conducting state of an inverter and a motor in a mode A.
Fig. 3 is a diagram illustrating the conducting state of the inverter and the motor in a mode B.
Fig. 4 is a diagram illustrating the conducting state of the inverter and the motor in a mode C.
Fig. 5 is a diagram illustrating the conducting state of the inverter and the motor in a mode D.
Fig. 6 is a diagram illustrating the conducting state of the inverter and the motor in a mode E.

Fig. 7 is a diagram illustrating the conducting state of the inverter and the motor in a mode F.

Fig. 8 is a diagram exemplifying variation in current in each phase of the motor caused by change in mode of the inverter.

Fig. 9 is a diagram for illustrating a sensor error of a current sensor.

Fig. 10 is a diagram illustrating processing for estimation by an electronic control unit (ECU), of a battery current value in accordance with a peak value from the current sensor.

Fig. 11 is a diagram schematically showing data stored in a memory.

Fig. 12 is a diagram illustrating an advantage of the embodiment.

Fig. 13 is a flowchart illustrating an exemplary procedure of processing performed by the ECU in the embodiment.

Fig. 14 is a flowchart exemplifying a procedure of estimation processing.

Fig. 15 is a flowchart exemplifying a procedure of failure diagnosis processing.

Fig. 16 is a flowchart illustrating another exemplary procedure of processing performed by the ECU in the embodiment.

Fig. 17 is a flowchart showing an exemplary procedure of determination processing.

Fig. 18 is a flowchart showing another exemplary procedure of determination processing.

Fig. 19 is a diagram of an overall configuration of a vehicle on which an estimation system according to a modification is mounted.

Fig. 20 is a flowchart illustrating an exemplary procedure of processing performed by the ECU in the modification.

## DESCRIPTION OF THE PREFERRED EMBODIMENTS

An embodiment of the present disclosure will be described in detail below with reference to the drawings. The same or corresponding elements in the drawings have the same reference characters allotted and description thereof will not be repeated. The embodiment illustrates an example in which an estimation system is mounted on a vehicle.

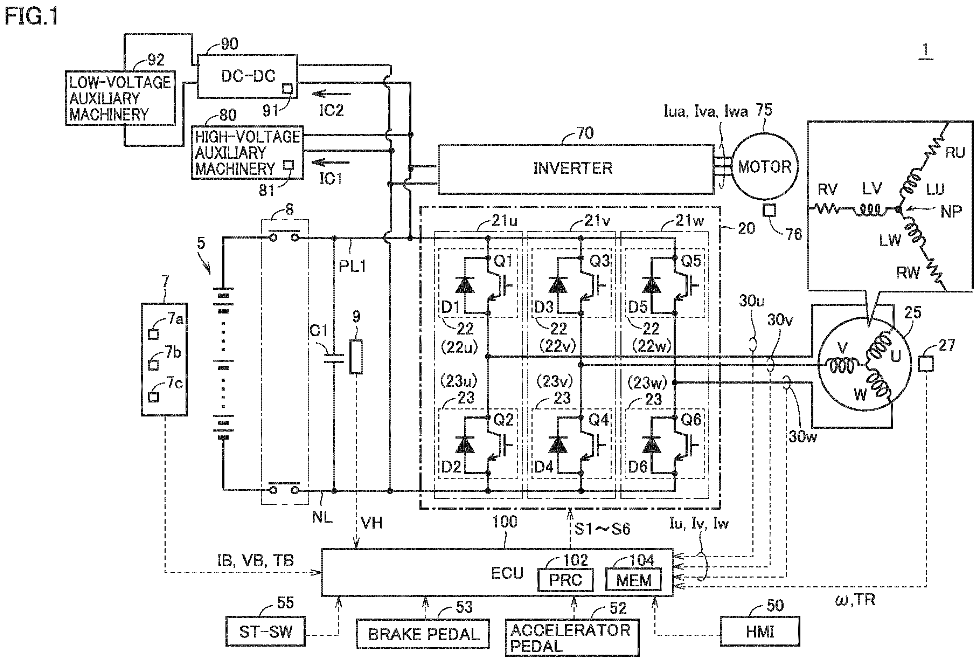

Fig. 1 is a diagram of an overall configuration of a vehicle on which an estimation system according to an embodiment is mounted. This vehicle is a four-wheel drive battery electric vehicle (BEV).

Referring to Fig. 1, a vehicle 1 includes a battery 5, a monitoring unit 7, a system main relay (SMR) 8, a capacitor C1, a voltage sensor 9, inverters 20 and 70, motors 25 and 75, and sensor units 27 and 76. Vehicle 1 further includes current sensors 30u, 30v, and 30w, a human machine interface (HMI) device 50, an accelerator pedal 52, a brake pedal 53, and a start switch (ST-SW) 55. Vehicle 1 further includes high-voltage auxiliary machinery 80, a direct-current (DC)-DC converter 90, and low-voltage auxiliary machinery 92.

Battery 5, monitoring unit 7, SMR 8, voltage sensor 9, inverters 20 and 70, motors 25 and 75, sensor units 27 and 76, current sensors 30u, 30v, and 30w, HMI device 50, high-voltage auxiliary machinery 80, DC-DC converter 90, and low-voltage auxiliary machinery 92 correspond to an exemplary "estimation system" in the present disclosure.

Battery 5 is a secondary battery such as a nickel metal hydride battery or a lithium ion battery. Battery 5 has a positive electrode connected to a positive electrode line PL1 with SMR 8 being interposed. Battery 5 has a negative electrode connected to a negative electrode line NL with SMR 8 being interposed. Battery 5 corresponds to an exemplary "power storage device" in the present disclosure.

Monitoring unit 7 includes a current sensor 7a, a voltage sensor 7b, and a temperature sensor 7c. Current sensor 7a, voltage sensor 7b, and temperature sensor 7c detect a current IB, a voltage VB, and a temperature TB of battery 5, respectively. Current sensor 7a corresponds to an exemplary "current detector" in the present disclosure.

SMR 8 is connected to battery 5. Capacitor C1 is connected between positive electrode line PL1 and negative electrode line NL, and smoothens voltage fluctuation between positive electrode line PL1 and negative electrode line NL. Voltage sensor 9 detects a voltage VH across positive electrode line PL1 and negative electrode line NL.

Inverter 20 is a three-phase inverter and connected to battery 5 with SMR 8 being interposed. Inverter 20 includes a leg circuit 21u, a leg circuit 21v, and a leg circuit 21w. Each of leg circuit 21u, leg circuit 21v, and leg circuit 21w includes an upper arm circuit 22 and a lower arm circuit 23 that is turned on and off in a manner complementary to upper arm circuit 22.

Upper arm circuits 22 of leg circuit 21u, leg circuit 21v, and leg circuit 21w are also expressed as upper arm circuits 22u, 22v, and 22w, respectively. Lower arm circuits 23 of leg circuit 21u, leg circuit 21v, and leg circuit 21w are also expressed as lower arm circuits 23u, 23v, and 23w, respectively.

A point intermediate between upper arm circuit 22u and lower arm circuit 23u is connected to a U-phase terminal of motor 25. A point intermediate between upper arm circuit 22v and lower arm circuit 23v is connected to a V-phase terminal of motor 25. A point intermediate between upper arm circuit 22w and lower arm circuit 23w is connected to a W-phase terminal of motor 25.

Upper arm circuit 22u includes a diode D1 and a switching element Q1. Lower arm circuit 23u includes a diode D2 and a switching element Q2. Upper arm circuit 22v includes a diode D3 and a switching element Q3. Lower arm circuit 23v includes a diode D4 and a switching element Q4. Upper arm circuit 22w includes a diode D5 and a switching element Q5. Lower arm circuit 23w includes a diode D6 and a switching element Q6. Each of switching elements Q1 to Q6 is implemented, for example, by an insulated gate bipolar transistor (IGBT) or a metal oxide semiconductor (MOS) transistor. Diodes D1 to D6 are connected in anti-parallel to switching elements Q1 to Q6, respectively.

Inverter 20 is configured to convert DC power supplied from battery 5 through SMR 8 into AC power and to supply resultant AC power to motor 25. Inverter 20 is also configured to convert AC power generated by motor 25 into DC power and to supply resultant DC power to battery 5. Operations of inverter 20 will be described in detail later.

Motor 25 is a three-phase AC motor connected to inverter 20 and a drive wheel (in this example, a not-shown front wheel) of vehicle 1. Motor 25 rotates by receiving three-phase AC power from inverter 20 to generate drive force for travel of vehicle 1. Motor 25 has a U-phase coil LU, a V-phase coil LV, and a W-phase coil LW connected to one another with a neutral point NP being interposed. A U-phase resistor, a V-phase resistor, and a W-phase resistor of motor 25 are also expressed as a U-phase resistor RU, a V-phase resistor RV, and a W-phase resistor RW, respectively.

Current sensors 30u, 30v, and 30w detect currents Iu, Iv, and Iw, respectively. Current Iu is an AC current that flows between U-phase coil LU and leg circuit 21u. Current Iv is an AC current that flows between V-phase coil LV and leg circuit 21v. Current Iw is an AC current that flows between W-phase coil LW and leg circuit 21w.

HMI device 50 gives various types of information to a user of vehicle 1 or receives various operations by the user. The operations by the user include an operation to indicate activation or deactivation of high-voltage auxiliary machinery 80 or low-voltage auxiliary machinery 92. Each of accelerator pedal 52 and brake pedal 53 is operated to set a request value of drive force for travel (a travel speed) of vehicle 1.

Start switch 55 is operated by the user to switch between an on state and an off state of a travel system of vehicle 1. The on state of the travel system corresponds to a closed state of SMR 8. The off state of the travel system corresponds to an open state of SMR 8. Sensor unit 27 detects a rotation speed $\omega$ of motor 25, torque TR, and a voltage in each phase.

Inverter 70 is a three-phase inverter. Inverter 70 is connected in parallel to inverter 20 with respect to battery 5, and configured to be activated by receiving electric power from battery 5. Inverter 70 includes three leg circuits (not shown) similarly to inverter 20. Inverter 70 is an exemplary "electrical apparatus" in the present disclosure.

Motor 75 is a three-phase AC motor. Motor 75 is connected to inverter 70 and activated (rotated) by receiving three-phase AC power supplied from inverter 70. Motor 75 is configured to drive a rear wheel (not shown) to generate drive force for travel of vehicle 1. In this example, it is assumed that drive force derived from motor 25 is used as main drive force for travel, while drive force derived from motor 75 is used in four-wheel drive of vehicle 1. Sensor unit 76 detects a rotation speed of motor 75, torque, a current in each phase (currents Iua, Iva, and Iwa), and a voltage in each phase.

Though an air-conditioner is employed as high-voltage auxiliary machinery 80 in this example, a battery heater may be applicable. High-voltage auxiliary machinery 80 is configured to be activated at an output voltage from battery 5 by receiving electric power from battery 5. High-voltage auxiliary machinery 80 is an exemplary "electrical apparatus" in the present disclosure. High-voltage auxiliary machinery 80 is provided with a current sensor 81. Current sensor 81 is configured to detect an input current IC1 to high-voltage auxiliary machinery 80. While high-voltage auxiliary machinery 80 is inactive, input current IC1 is zero.

DC-DC converter 90 is a power converter configured to be activated by receiving electric power from battery 5. DC-DC converter 90 lowers an output voltage from battery 5 (for example, to 12 V). DC-DC converter 90 is an exemplary "electrical apparatus" in the present disclosure. DC-DC converter 90 is provided with a current sensor 91. Current sensor 91 is configured to detect an input current IC2 to DC-DC converter 90. While DC-DC converter 90 is inactive, input current IC2 is zero.

For example, an audio device is employed as low-voltage auxiliary machinery 92. Low-voltage auxiliary machinery 92 is activated at a voltage lowered by DC-DC converter 90.

An ECU 100 includes a processor 102 and a memory 104. Processor 102 is, for example, a central processing unit (CPU), and performs various types of computing processing. Memory 104 includes a read only memory (ROM) and a random access memory (RAM) (neither of which is shown). A program executed by processor 102 is stored in the ROM.

ECU 100 controls various devices of vehicle 1 such as SMR 8, inverters 20 and 70, motors 25 and 75, HMI device 50, high-voltage auxiliary machinery 80, DC-DC converter 90, and low-voltage auxiliary machinery 92. ECU 100 controls the various devices in accordance with detection values from monitoring unit 7, voltage sensor 9, sensor units 27 and 76, and current sensors 30u, 30v, 30w, 81, and 91, an amount of operation onto accelerator pedal 52 or brake pedal 53, or an operation by the user onto HMI device 50 or start switch 55. ECU 100 estimates a state of charge (SOC) of battery 5 in accordance with the detection value from monitoring unit 7.

ECU 100 is configured to deactivate high-voltage auxiliary machinery 80 when power consumption by high-voltage auxiliary machinery 80 is less than a reference amount of consumption. Similarly, ECU 100 is configured to deactivate DC-DC converter 90 when power consumption by low-voltage auxiliary machinery 92 is less than the reference amount of consumption. A value indicating the reference amount of consumption is stored in memory 104.

ECU 100 is configured to deactivate inverter 70 of inverters 20 and 70 when a request value for drive force for travel of vehicle 1 is smaller than a reference request value (for example, when an opening of accelerator pedal 52 is smaller than a prescribed opening). While inverter 70 is inactive, vehicle 1 travels by two-wheel drive so long as inverter 20 is active. A value indicating the reference request value is stored in memory 104.

ECU 100 turns on and off each of upper arm circuits 22u, 22v, and 22w. Turn-on and -off of upper arm circuits 22u, 22v, and 22w corresponds to turn-on and - off of respective switching elements Q1, Q3, and Q5. ECU 100 turns on and off each of lower arm circuits 23u, 23v, and 23w. Turn-on and -off of lower arm circuits 23u, 23v, and 23w corresponds to turn-on and -off of respective switching elements Q2, Q4, and Q6. ECU 100 turns on and off lower arm circuits 23u, 23v, and 23w in a manner complementary to respective upper arm circuits 22u, 22v, and 22w.

ECU 100 controls on and off of switching elements Q1 to Q6 through signals S1 to S6 to thereby control inverter 20.

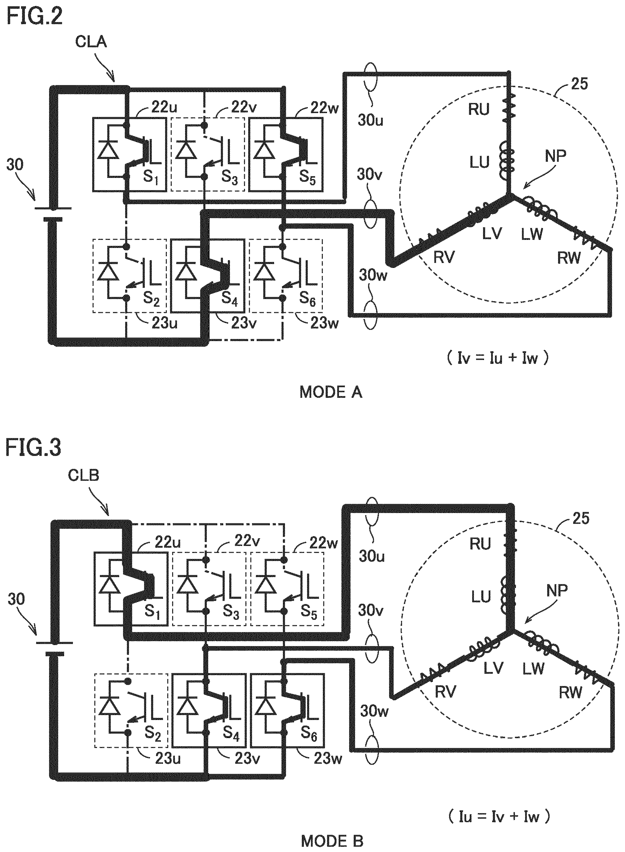

Operations of inverter 20 will be described with reference to Figs. 2 to 7. In the description with reference to Figs. 2 to 7, it is assumed that SMR 8 is closed and inverter 70 (motor 75), high-voltage auxiliary machinery 80, and DC-DC converter 90 are inactive. As will be described below, a mode (switching state) of inverter 20 includes a mode A to a mode F.

Fig. 2 is a diagram illustrating a conducting state of inverter 20 and motor 25 in mode A. Referring to Fig. 2, in mode A, upper arm circuits 22u and 22w and lower arm circuit 23v are on and upper arm circuit 22v and lower arm circuits 23u and 23w are off. A closed-loop circuit composed of upper arm circuit 22u and upper arm circuit 22w, neutral point NP, lower arm circuit 23v, and battery 5 is also expressed as a "loop circuit CLA" (a portion shown with a bold line in Fig. 2). Mode A corresponds to an exemplary "fourth mode" in the present disclosure.

Fig. 3 is a diagram illustrating the conducting state of inverter 20 and motor 25 in mode B. Referring to Fig. 3, in mode B, upper arm circuit 22u and lower arm circuits 23v and 23w are on and upper arm circuits 22v and 22w and lower arm circuit 23u are off. A closed-loop circuit composed of upper arm circuit 22u, neutral point NP, lower arm circuit 23v and lower arm circuit 23w, and battery 5 is also expressed as a "loop circuit CLB" (a portion shown with a bold line in Fig. 3). Mode B corresponds to an exemplary "first mode" in the present disclosure.

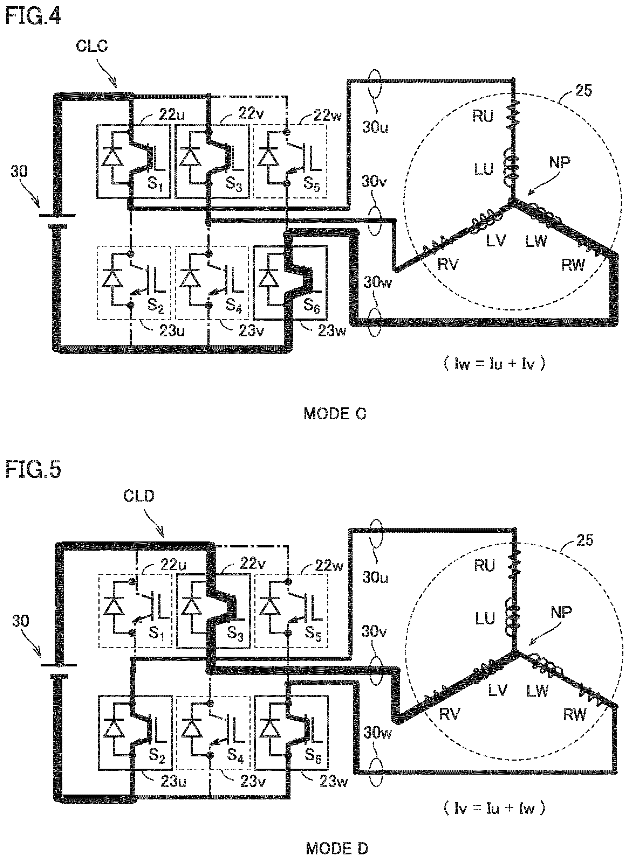

Fig. 4 is a diagram illustrating the conducting state of inverter 20 and motor 25 in mode C. Referring to Fig. 4, in mode C, upper arm circuits 22u and 22v and lower arm circuit 23w are on and upper arm circuit 22w and lower arm circuits 23u and 23v are off. A closed-loop circuit composed of upper arm circuits 22u and 22v, neutral point NP, lower arm circuit 23w, and battery 5 is also expressed as a "loop circuit CLC" (a portion shown with a bold line in Fig. 4).

Fig. 5 is a diagram illustrating the conducting state of inverter 20 and motor 25 in mode D. Referring to Fig. 5, in mode D, upper arm circuit 22v and lower arm circuits 23u and 23w are on and upper arm circuits 22u and 22w and lower arm circuit 23v are off. A closed-loop circuit composed of upper arm circuit 22v, neutral point NP, lower arm circuit 23u and lower arm circuit 23w, and battery 5 is also expressed as a "loop circuit CLD" (a portion shown with a bold line in Fig. 5). Mode D corresponds to an exemplary "third mode" in the present disclosure.

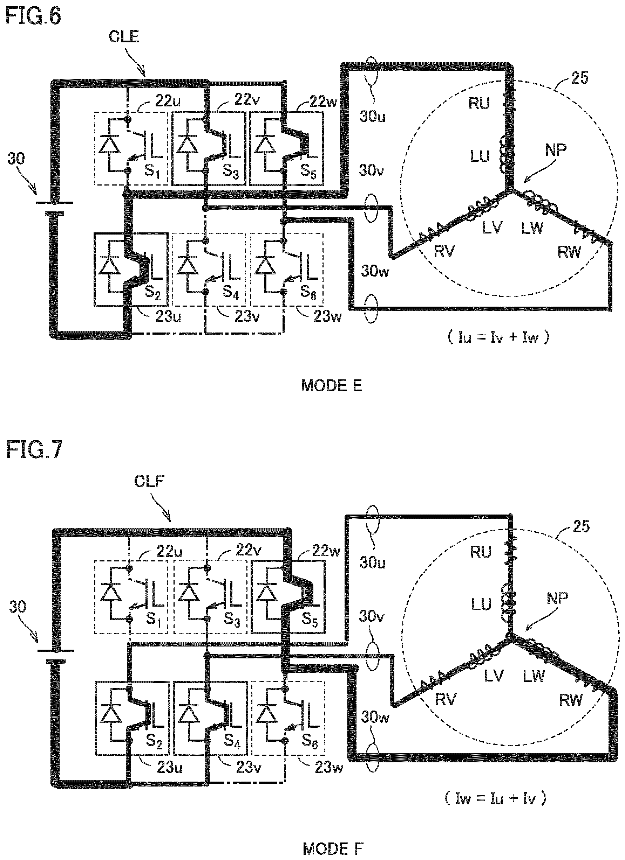

Fig. 6 is a diagram illustrating the conducting state of inverter 20 and motor 25 in mode E. Referring to Fig. 6, in mode E, upper arm circuits 22v and 22w and lower arm circuit 23u are on and upper arm circuit 22u and lower arm circuits 23v and 23w are off. A closed-loop circuit composed of lower arm circuit 23u, neutral point NP, upper arm circuit 22v and upper arm circuit 22w, and battery 5 is also expressed as a "loop circuit CLE" (a portion shown with a bold line in Fig. 6). Mode E corresponds to an exemplary "second mode" in the present disclosure.

Fig. 7 is a diagram illustrating the conducting state of inverter 20 and motor 25 in mode F. Referring to Fig. 7, in mode F, upper arm circuit 22w and lower arm circuits 23u and 23v are on and upper arm circuits 22u and 22v and lower arm circuit 23w are off. A closed-loop circuit composed of upper arm circuit 22w, neutral point NP, lower arm circuits 23u and 23v, and battery 5 is also expressed as a "loop circuit CLF" (a portion shown with a bold line in Fig. 7).

Mode A to mode F may be modes in either of power running or regeneration of vehicle 1.

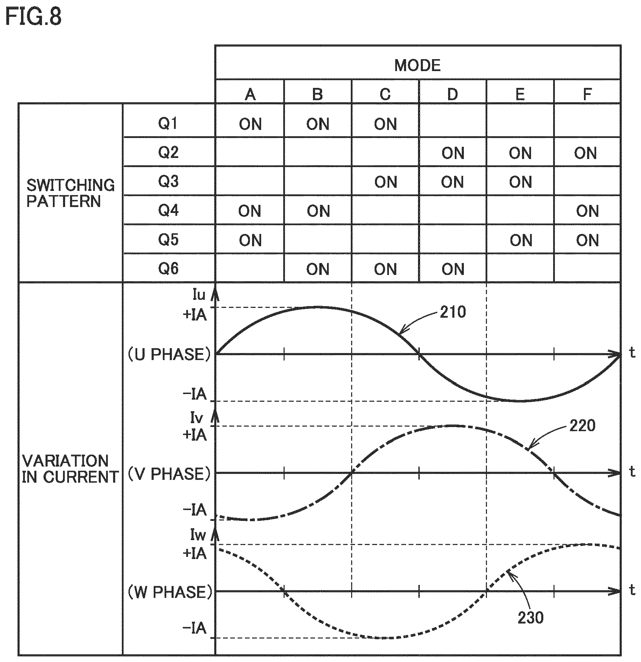

Fig. 8 is a diagram exemplifying variation in current in each phase of motor 25 caused by change in mode of inverter 20. This figure shows in a list, also relation between the on and off states (switching patterns) of switching elements Q1 to Q6 and each mode.

Referring to Fig. 8, in a lower part, the ordinate represents magnitude of a current in each phase (current Iu, Iv, or Iw) and the abscissa represents time. An amplitude of the current in each phase is represented as IA. Lines 210, 220, and 230 schematically show how respective currents Iu, Iv, and Iw vary with change in mode. When magnitude of the current is positive, the current flows from the positive electrode of battery 5 toward neutral point NP. When magnitude of the current is negative, the current flows from neutral point NP toward the negative electrode of battery 5. In this example, strain (harmonic component) of the current in each phase is not drawn for facilitation of understanding.

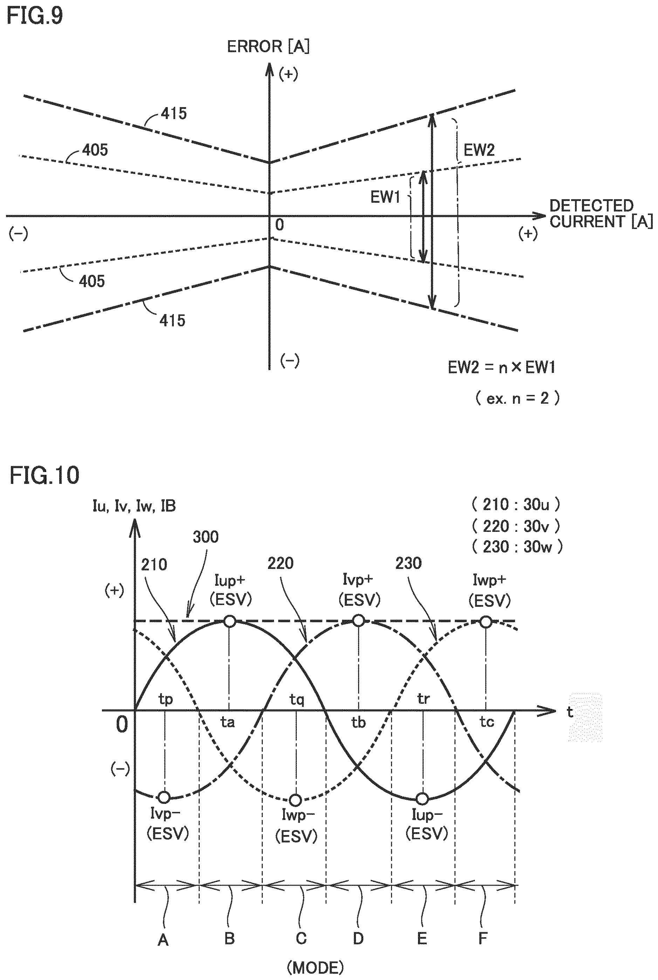

Fig. 9 is a diagram for illustrating a sensor error of the current sensor. Referring to Fig. 9, lines 405 represent relation between a current detected by a certain current sensor and an upper limit and a lower limit of a possible range of a sensor error of this current sensor. This current sensor is, for example, current sensor 30u, 30v, 30w, 81, or 91. The sensor error may include an offset error and a gain error. The offset error is an error from an ideal value (0) irrelevant to magnitude of a detected current. The gain error is an error that increases as magnitude of a detected current increases. A width EW1 is a width of the possible range of the sensor error of the current sensor.

Lines 415 represent relation between a current detected by each current sensor when each of n (n = 2 in this example) current sensors detects the current and an upper limit and a lower limit of a possible range of a total of sensor errors of the current sensors. A width EW2 represents a range of the possible range of the total of the sensor errors and it is larger than width EW1. Thus, as a larger number of current sensors are used (as n increases), influence by the sensor error is greater.

Referring again to Fig. 1, in order to accurately estimate the SOC of battery 5, an error included in a detection value of current IB should be small. In order for such an error to be small, it is important that current sensor 7a is not faulty (is normal). One technique for diagnosis as to whether or not current sensor 7a has failed is to incorporate a redundant battery current sensor (not shown) different from current sensor 7a in vehicle 1 and to calculate a difference between a detection value from this redundant current sensor and a detection value from current sensor 7a. When this difference is relatively small, current sensor 7a is diagnosed as being normal. When the difference is relatively large, on the other hand, current sensor 7a (or the redundant battery current sensor) is diagnosed as having failed.

Incorporation of a redundant current sensor in vehicle 1 for diagnosis as to failure of current sensor 7a leads to increase in cost. In order to avoid such increase in cost, current IB is preferably estimated without the redundant current sensor. By calculation of a difference between an estimated value of current IB and a detection value of current IB (detection value from current sensor 7a), whether or not current sensor 7a has failed can be diagnosed based on whether this difference is large or small.

In the embodiment, ECU 100 is configured to perform estimation processing for estimating a current value of battery 5 (battery current value) without depending on a detection value from current sensor 7a. Estimation of the battery current value corresponds to calculation of the estimated value of current IB. ECU 100 performs the estimation processing while the travel system of vehicle 1 is on.

Prior to explanation of the estimation processing by ECU 100, a technique for estimation of current IB by the ECU in a comparative example will be described below. In the comparative example, it is assumed that SMR 8 is closed and all of inverter 70 (motor 75), high-voltage auxiliary machinery 80, and DC-DC converter 90 are active.

The ECU in the comparative example estimates current IB in accordance with an expression (1) below.

$$\text{(Estimated value of current IB)} = \text{(detection value of input current IC1)} + \text{(detection value of input current IC2)} + \text{(calculated value of estimated current of inverter 20)} + \text{(calculated value of estimated current of inverter 70)} \tag{1}$$

The third term in the right side of the expression (1) corresponds to a result of division of a difference between an output (a product of the number of rotations ω and torque TR) from motor 25 and power loss in motor 25 by a detection value (voltage VH) from voltage sensor 9. The power loss is calculated in accordance with the detection value of the current in each phase (current Iu, Iv, or Iw) of motor 25, a resistance value in each phase, and the number of rotations ω. Similarly, the fourth term in the right side corresponds to a result of division of a difference between an output (a product of the number of rotations and torque) from motor 75 and power loss in motor 75 by voltage VH. The power loss is calculated in accordance with the detection value of the current in each phase, a resistance value in each phase, and the number of rotations of motor 75.

In order to estimate current IB as in the comparative example, detection values from a large number of sensors including current sensors 30u to 30w, 81, and 91 and sensor units 27 and 76 are required. As described previously, the detection value from each sensor may include an error such as an offset error and a gain error. When the battery current value is estimated from a large number of detection values as in the comparative example, the estimated value is affected by a large number of sensor errors included in the large number of detection values. Consequently, errors originating from sensor errors are accumulated in the estimated value and accuracy of the estimated value of current IB may become lower. Therefore, in the comparative example, current IB may not accurately be estimated.

Processing for estimation of current IB performed by ECU 100 in the embodiment will be described below with reference again to Figs. 1 to 3, 5, and 6.

ECU 100 performs first processing for estimating a battery current value in accordance with a detection value from current sensor 30u (current Iu) when the mode of inverter 20 is set to mode B (Fig. 3) or mode E (Fig. 6). The first processing is included in the estimation processing described previously. The first processing corresponds to estimation of current IB, for example, in accordance with an expression (2) below.

$$\text{(Estimated value of current IB)} = \text{(detection value of input current IC1)} + \text{(detection value of input current IC2)} + \text{(detection value of current Iu)} + \text{(detection value of current Iua)} \tag{2}$$

The expression (2) is different from the expression (1) in the comparative example in that the detection value of current Iu and the detection value of current Iua are used instead of the calculated values of the estimated currents of inverters 20 and 70. The fourth term (the detection value of current Iua) in the right side in the expression (2) may be expressed as a value of an input and output current to and from inverter 70 determined based on detection values of currents Iua, Iva, and Iwa.

In the embodiment, an example in which ECU 100 performs the first processing, for example, while inverter 70 (motor 75), high-voltage auxiliary machinery 80, and DC-DC converter 90 are inactive will mainly be described. In this case, since the first term, the second term, and the fourth term in the right side in the expression (2) are not required for estimation of current IB, the expression (2) is expressed in an expression (3) below.

$$\text{(Estimated value of current IB)} = \text{(detection value of current Iu)} \quad ... (3)$$

According to the expression (3), the current value of the battery is estimated on the assumption that the detection value from current sensor 30u is equal to the battery current value in loop circuit CLB (Fig. 3) or loop circuit CLE (Fig. 6). Thus, the detection value from current sensor 30u is used as it is as the battery current value. In other words, only the detection value from current sensor 30u is enough for estimation of the battery current value, and detection values from a large number of other sensors are not required. Consequently, such a situation as lowering in accuracy in estimation of the battery current value due to use of detection values from a large number of sensors is avoided. Therefore, the battery current value can accurately be estimated.

Similarly, ECU 100 can also perform second processing for estimating the battery current value in accordance with the detection value (current Iv) from current sensor 30v when the mode of inverter 20 is set to mode D (Fig. 5) or mode A (Fig. 2). The second processing is included in the estimation processing described previously. The second processing corresponds, for example, to estimation of current IB in accordance with an expression (4) below.

(Estimated value of current IB) = (detection value of input current IC1) + (detection value of input current IC2) + (detection value of current Iv) + (detection value of current Iva)   (4)

The fourth term in the right side in the expression (4) may be expressed as a value of an input and output current to and from inverter 70 determined based on detection values of currents Iua, Iva, and Iwa.

ECU 100 performs the second processing, for example, while inverter 70, high-voltage auxiliary machinery 80, and DC-DC converter 90 are inactive. In this case, the expression (4) is expressed in an expression (5) below.

$$\text{(Estimated value of current IB)} = \text{(detection value of current Iv)} \quad ... (5)$$

According to the expression (5), the battery current value is estimated on the assumption that the detection value from current sensor 30v is equal to the battery current value in loop circuit CLD (Fig. 5) or loop circuit CLA (Fig. 2). Thus, for a reason similar to that in the first processing, the battery current value can accurately be estimated.

Similarly, ECU 100 can also perform third processing for estimating the battery current value in accordance with the detection value (current Iw) from current sensor 30w when the mode of inverter 20 is set to mode C (Fig. 4) or mode F (Fig. 7).

The first processing, the second processing, and the third processing correspond to processing for estimating the battery current value in accordance with peaks (peak values) of the detection values from respective current sensors 30u, 30v, and 30w, which will be described in detail below.

Fig. 10 is a diagram illustrating processing for estimation by ECU 100, of the battery current value in accordance with the peak values from current sensors 30u, 30v, and 30w. This figure is based on Fig. 8.

Referring to Fig. 10, lines 210, 220, and 230 are the same as described with reference to Fig. 8. A line 300 schematically represents the battery current value (a value of a DC current). Peak values Iup+, Ivp+, and Iwp+ are positive peak values of the detection values from respective current sensors 30u, 30v, and 30w.

At time ta, current sensor 30u detects peak value Iup+ (line 210). ECU 100 determines peak value Iup+ as an estimated value ESV of the battery current value. After time ta, current Iu lowers while current Iv increases (line 220).

At time tb, current sensor 30v detects peak value Ivp+. ECU 100 determines peak value Ivp+ as estimated value ESV. In this case, the second processing described previously corresponds to processing for estimating the battery current value in accordance with peak value Ivp+ of the detection value from current sensor 30v after detection by current sensor 30u of peak value Iup+ at time ta. After time tb, current Iv lowers while current Iw increases (line 230).

At time tc, current sensor 30w detects peak value Iwp+. ECU 100 determines peak value Iwp+ as estimated value ESV. After time tc, current Iw lowers while current Iu increases.

ECU 100 performs the estimation processing also at time tp, time tq, and time tr in accordance with peak values Ivp-, Iwp-, and Iup-, respectively. Peak values Iup-, Ivp-, and Iwp- are negative peak values of detection values from current sensors 30u, 30v, and 30w, respectively. In this case, at time tp, estimated value ESV is peak value Ivp-. At time tq, estimated value ESV is peak value Iwp-. At time tr, estimated value ESV is peak value Iup-.

Thus, ECU 100 determines peak values Iup+, Ivp+, Iwp+, Ivp-, Iwp-, and Iup-as estimated values ESV at time ta, time tb, time tc, time tp, time tq, and time tr, respectively. Thus, the difference between the battery current value (line 300) and estimated value ESV can be minimized. Each of peak values Iup+, Ivp+, Iwp+, Iup-, Ivp-, and Iwp- corresponds to an exemplary "peak value" in the present disclosure.

Estimated value ESV makes transition among peak values Ivp-, Iup+, Iwp-, Ivp+, Iup-, and Iwp+ in this order. Actually, the battery current value varies depending on change over time in SOC of battery 5, and hence these peak values may also vary depending on time t.

In this example, the first processing, the second processing, and the third processing described previously are performed every half cycle of currents Iu, Iv, and Iw, respectively (for example, the first processing is performed at time ta and time tr, the second processing is performed at tp and tb, and the third processing is performed at tq and tc). Estimated value ESV is thus determined not only every half cycle of current Iu but also every half cycle of current Iv and every half cycle of current Iw. Consequently, ECU 100 can use more peak values as estimated values ESV than in an example only the first processing is performed. ECU 100 can confirm that none of current sensors 30u, 30v, and 30w has failed, for example, based on the fact that a difference between a maximum value and a minimum value of absolute values of peak values Ivp-, Iup+, Iwp-, Ivp+, Iup-, and Iwp+ is smaller than a prescribed minute value (if this difference is larger than the minute value, at least one current sensor may have failed). ECU 100 can thus confirm high reliability of estimated value ESV based on the detection values from current sensors 30u, 30v, and 30w. The minute value is stored in memory 104.

ECU 100 is also configured to perform failure diagnosis processing for diagnosing whether or not current sensor 7a has failed, for example, by comparing the detection value (peak value Iup+ by way of example) from current sensor 30u with the detection value from current sensor 7a (for example, determining whether or not a difference between these detection values is smaller than a threshold value).

For example, when the difference is equal to or larger than the threshold value, the detection value of the battery current value is different from the estimated value and hence current sensor 7a may have failed. When the difference is smaller than the threshold value, on the other hand, the detection value of the battery current value is close to the estimated value and hence current sensor 7a is considered as being normal. Since the estimated value of the battery current value is accurately calculated in the embodiment, whether or not current sensor 7a has failed can accurately be diagnosed. The failure diagnosis processing is completed in several seconds.

ECU 100 may perform the failure diagnosis processing, for example, when the difference between the maximum value and the minimum value of the absolute values of peak values Ivp-, Iup+, Iwp-, Ivp+, Iup-, and Iwp+ is smaller than the minute value described previously. Whether or not current sensor 7a has failed is thus diagnosed when reliability of estimated value ESV is high. Consequently, reliability of the failure diagnosis processing can be guaranteed.

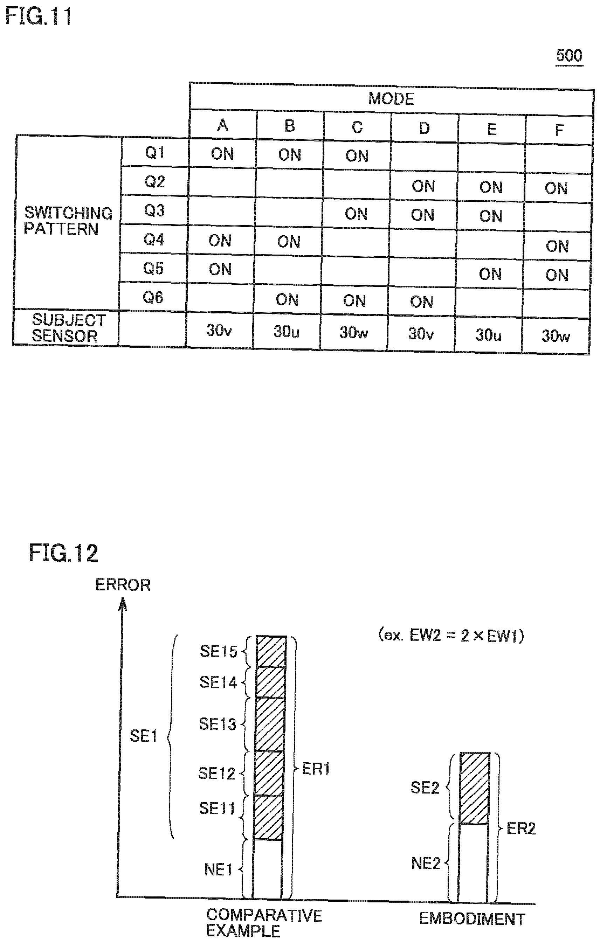

Fig. 11 is a diagram schematically showing data stored in memory 104. Referring to Fig. 11, data 500 represents relation between the current sensor (subject sensor) to be used for determination of estimated value ESV and the mode of inverter 20. The subject sensor is set for each mode of inverter 20.

Referring again to Fig. 1, in the embodiment, ECU 100 performs the estimation processing while at least one of inverter 70, high-voltage auxiliary machinery 80, and DC-DC converter 90 is inactive.

When inverter 70, high-voltage auxiliary machinery 80, and DC-DC converter 90 are activated, electric power is supplied from battery 5 not only to inverter 20 (motor 25) but also to inverter 70, high-voltage auxiliary machinery 80, and DC-DC converter 90 (the input current to inverter 70 and input currents IC1 and IC2 flow). Therefore, while at least one of inverter 70, high-voltage auxiliary machinery 80, and DC-DC converter 90 is active, the detection value from current sensor 30u is not necessarily equal to the battery current value.

The estimation processing is performed while at least one of inverter 70, high-voltage auxiliary machinery 80, and DC-DC converter 90 is inactive as described above, so that the battery current value can be estimated while at least one of the input current to inverter 70 and input currents IC1 and IC2 does not flow. At least one of the detection value of the input current to inverter 70, the detection value from current sensor 81, and the detection value from current sensor 91 is thus not required. Therefore, the number of sensors to be used for estimation of the battery current value can be smaller than in the example where the battery current value is estimated based on the detection values from current sensors 30u, 81, and 91 and the detection value from sensor unit 76 while all of the input current to inverter 70 and input currents IC1 and IC2 flow (specifically, the value of current IB is estimated as the total of the detection values of the input current to inverter 70 and input currents IC1 and IC2 and the detection value of current Iu). Consequently, the battery current value can accurately be estimated.

Preferably, ECU 100 performs the estimation processing while all of inverter 70, high-voltage auxiliary machinery 80, and DC-DC converter 90 are inactive. Estimation processing is thus performed while none of the input current to inverter 70 and input currents IC1 and IC2 flows. Consequently, the battery current value can be estimated on the assumption that the detection value from current sensor 30u is equal to the battery current value. Therefore, the number of sensors to be used for estimation of the battery current value can be minimum necessary, and accuracy in estimation of the battery current value can thus further be enhanced.

ECU 100 performs the estimation processing, for example, in accordance with the expression (2) or the expression (4) when at least one of inverter 70 (motor 75), high-voltage auxiliary machinery 80, and DC-DC converter 90 is active. By thus performing the estimation processing as well, the number of sensors to be used for estimation of the battery current value can be smaller than in the comparative example where the estimated current of inverter 20 (the third term in the right side in the expression (1)) is calculated.

Fig. 12 is a diagram illustrating an advantage of the embodiment. Referring to Fig. 12, this example shows an estimated error of the battery current value in each of the comparative example and the embodiment.

In the comparative example, an estimated error ER1 includes a noise-derived error NE1 and a sensor-derived error SE1. Noise-derived error NE1 is derived, for example, from switching noise from switching elements Q1 to Q6. Since the battery current value is estimated in accordance with the expression (1), sensor-derived error SE1 includes errors SE11 to SE15. Error SE11 is derived from a sensor error of voltage sensor 9 in regard to voltage VH. Error SE12 is derived from a sensor error of sensor unit 27 in regard to rotation speed $\omega$. Error SE13 is derived from a sensor error of sensor unit 27 in regard to torque TR. Error SE14 is derived from a calculation error of power loss of inverter 20 due to sensor errors of current sensors 30u to 30w. Error SE15 is derived from sensor errors of current sensors 81 and 91.

In the embodiment, an estimated error ER2 includes a noise-derived error NE2 and a sensor-derived error SE2. Noise-derived error NE2 is derived, for example, from switching noise as in the comparative example. Sensor-derived error SE2 is a sensor error of the subject sensor (for example, current sensor 30u) described previously. In this example, a sensor other than the subject sensor is not required for estimation of the battery current value. Therefore, increase of sensor errors due to increase in number of sensors can be prevented. Consequently, the battery current can be estimated more accurately than in the comparative example (ER2 < ER1).

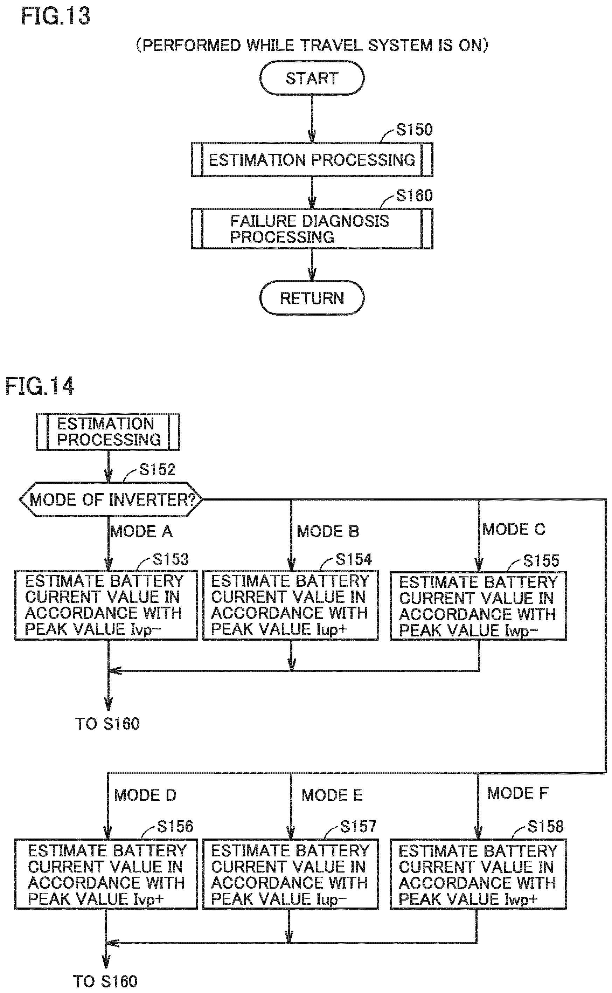

Fig. 13 is a flowchart illustrating an exemplary procedure of processing performed by ECU 100 in the embodiment. This flowchart is performed every prescribed cycle while the travel system is on. A step will be abbreviated as "S" below.

Referring to Fig. 13, ECU 100 performs the estimation processing for estimating the battery current value (S150) and performs the failure diagnosis processing in accordance with a result of the estimation processing (S160). After S160, the process makes transition to return. A procedure in S150 and S160 will be described in detail below.

Fig. 14 is a flowchart exemplifying a procedure of the estimation processing. Figs. 2 to 7, 10, and 11 are referred to as appropriate in the description of this flowchart.

Referring to Fig. 14, ECU 100 uses data 500 to switch processing in accordance with the mode of inverter 20 (S152).

When the mode of inverter 20 is set to mode A, ECU 100 determines current sensor 30v as the subject sensor and estimates the battery current value in accordance with peak value Ivp- (S153). In this example, ECU 100 determines peak value Ivp-as estimated value ESV.

When the mode of inverter 20 is set to mode B, ECU 100 determines current sensor 30u as the subject sensor and estimates the battery current value in accordance with peak value Iup+ (S154). In this example, ECU 100 determines peak value Iup+ as estimated value ESV.

When the mode of inverter 20 is set to mode C, ECU 100 determines current sensor 30w as the subject sensor and estimates the battery current value in accordance with peak value Iwp- (S155). In this example, ECU 100 determines peak value Iwp-as estimated value ESV.

When the mode of inverter 20 is set to mode D, ECU 100 determines current sensor 30v as the subject sensor and estimates the battery current value in accordance with peak value Ivp+ (S156). In this example, ECU 100 determines peak value Ivp+ as estimated value ESV.

When the mode of inverter 20 is set to mode E, ECU 100 determines current sensor 30u as the subject sensor and estimates the battery current value in accordance with peak value Iup- (S157). In this example, ECU 100 determines peak value Iup-as estimated value ESV.

When the mode of inverter 20 is set to mode F, ECU 100 determines current sensor 30w as the subject sensor and estimates the battery current value in accordance with peak value Iwp+ (S158). In this example, ECU 100 determines peak value Iwp+ as estimated value ESV.

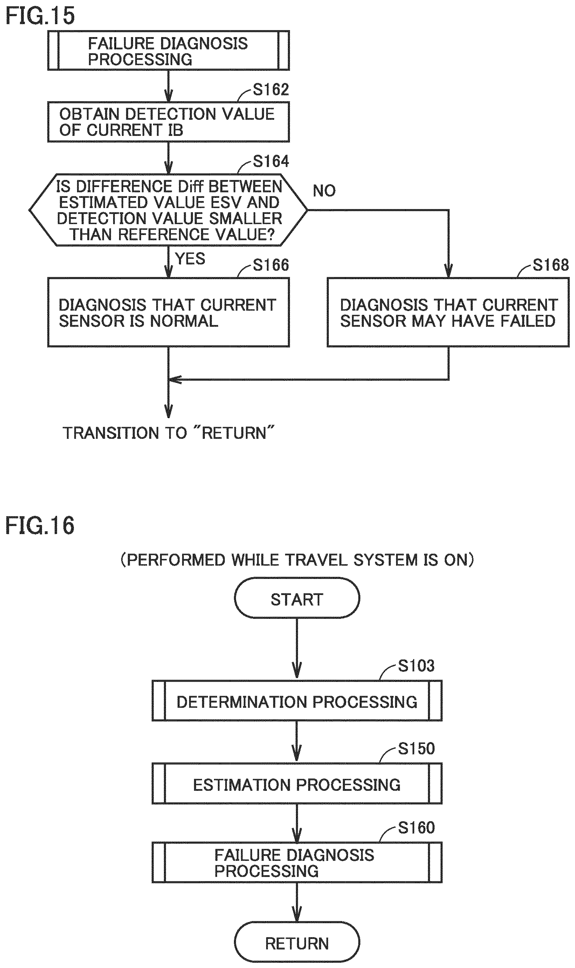

Fig. 15 is a flowchart exemplifying a procedure of the failure diagnosis processing. Referring to Fig. 15, ECU 100 obtains the detection value of current IB from current sensor 7a (S162).

ECU 100 determines whether or not a difference Diff between estimated value ESV and the detection value of current IB is smaller than a reference value (S164). When difference Diff is smaller than the reference value (YES in S164), ECU 100 diagnoses current sensor 7a as being normal (S166). When difference Diff is equal to or larger than the reference value (NO in S164), ECU 100 diagnoses that current sensor 7a may have failed (S168). After S166 or S168, the process makes transition to "return" in Fig. 13.

Fig. 16 is a flowchart illustrating another exemplary procedure of processing performed by ECU 100 in the embodiment. Though this flowchart is different from the flowchart in Fig. 13 in addition of S103, it is otherwise the same as the flowchart in Fig. 13.

Referring to Fig. 16, ECU 100 performs determination processing for determining whether or not at least one of inverter 70 (motor 75), high-voltage auxiliary machinery 80, and DC-DC converter 90 is inactive (S103).

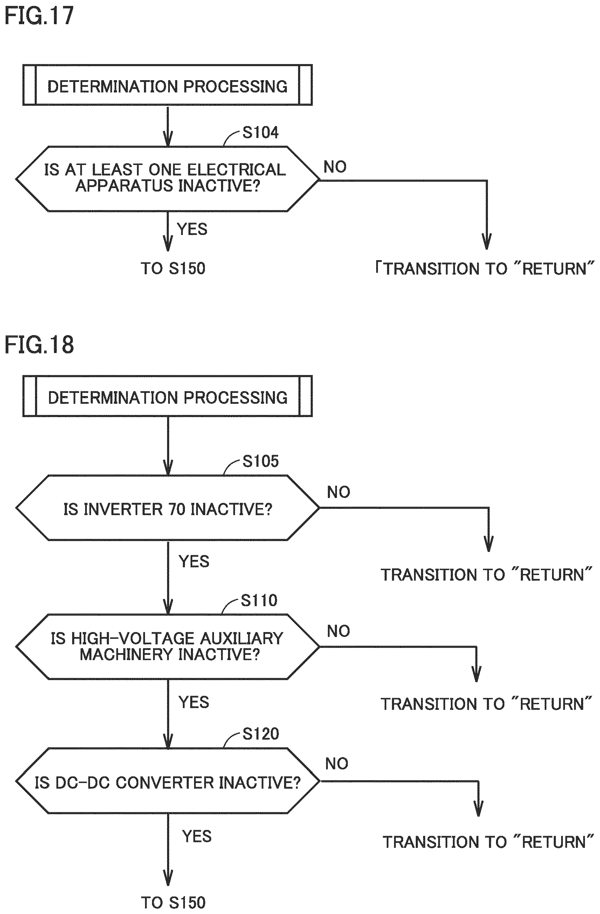

Fig. 17 is a flowchart showing an exemplary procedure of this determination processing. Referring to Fig. 17, ECU 100 determines whether or not at least one electrical apparatus of inverter 70, high-voltage auxiliary machinery 80, and DC-DC converter 90 is inactive (S104). When the at least one electrical apparatus is inactive (YES in S104), the process proceeds to S150. When all of inverter 70, high-voltage auxiliary machinery 80, and DC-DC converter 90 are active (NO in S104), the process makes transition to "return" in Fig. 16.

Fig. 18 is a flowchart showing another exemplary procedure of the determination processing. Referring to Fig. 18, this flowchart is different from the flowchart in Fig. 17 in that S105, S110, and S120 are performed instead of S104.

Referring to Fig. 18, ECU 100 switches processing in accordance with whether or not inverter 70 is inactive (S105). Specifically, ECU 100 determines whether or not the request value for drive force for travel is smaller than a reference request value based on the opening of accelerator pedal 52 and the opening of brake pedal 53 and switches the processing in accordance with a result of this determination. When inverter 70 is active (NO in S105), the process makes transition to "return" in Fig. 16. When inverter 70 is inactive (YES in S105), the process proceeds to S110.

ECU 100 switches the processing in accordance with whether or not high-voltage auxiliary machinery 80 is inactive (S110). Specifically, ECU 100 switches the processing in accordance with whether or not activation of high-voltage auxiliary machinery 80 is indicated with the use of HMI device 50. When high-voltage auxiliary machinery 80 is active (NO in S110), the process makes transition to "return". When high-voltage auxiliary machinery 80 is inactive (YES in S110), the process proceeds to S120.

ECU 100 switches the processing in accordance with whether or not DC-DC converter 90 is inactive (S120). Specifically, ECU 100 switches the processing in accordance with whether or not activation of low-voltage auxiliary machinery 92 is indicated with the use of HMI device 50. When DC-DC converter 90 is active (NO in S120), the process makes transition to "return". When DC-DC converter 90 is inactive (YES in S120), the process proceeds to S150.

In the example in Fig. 18, ECU 100 determines whether or not all of inverter 70, high-voltage auxiliary machinery 80, and DC-DC converter 90 are inactive, and when all of them are inactive, ECU 100 performs the estimation processing (S150) and the failure diagnosis processing (S160).

If the vehicle does not include two or more inverters (motors for travel), S105 does not have to be performed. Since vehicle 1 includes two or more motors for travel (motors 25 and 75) in the embodiment (YES in S105), the process proceeds to S110.

ECU 100 may deactivate high-voltage auxiliary machinery 80 prior to the estimation processing based on the fact that power consumption by high-voltage auxiliary machinery 80 is less than a reference amount of consumption even when high-voltage auxiliary machinery 80 is active. In this case, the process proceeds from S110 to S120. Similarly, ECU 100 may deactivate DC-DC converter 90 prior to the estimation processing based on the fact that power consumption by low-voltage auxiliary machinery 92 is less than a reference amount of consumption even when DC-DC converter 90 is active. In this case, the process proceeds from S120 to S150.

As described previously, the failure diagnosis processing is completed in several seconds. Therefore, even when at least one apparatus (for example, all) of high-voltage auxiliary machinery 80 and DC-DC converter 90 is deactivated as above prior to the failure diagnosis processing (estimation processing), ECU 100 does not have to deactivate the at least one apparatus for a long period. Therefore, lowering in usability is avoided.

As set forth above, according to the embodiment, the battery current value can accurately be estimated. The embodiment is particularly effective in estimation of the battery current value of a vehicle incorporating a plurality of motors such as vehicle 1 (a four-wheel drive electrically powered vehicle). Such a vehicle generally includes a large number of sensors. Estimation of the battery current value based on detection values from these sensors as in the comparative example may be low in accuracy. In the embodiment, on the other hand, the battery current value can be estimated with the use of the minimum necessary number of current sensors (for example, only current sensor 30u, 30v, or 30w) even in such a vehicle and thus accuracy in estimation of the battery current value can be enhanced. Consequently, whether or not current sensor 7a has failed can accurately be diagnosed without a redundant current sensor. Therefore, increase in weight and cost of vehicle 1 due to incorporation of a redundant current sensor in vehicle 1 can be avoided.

[Modification of Embodiment]

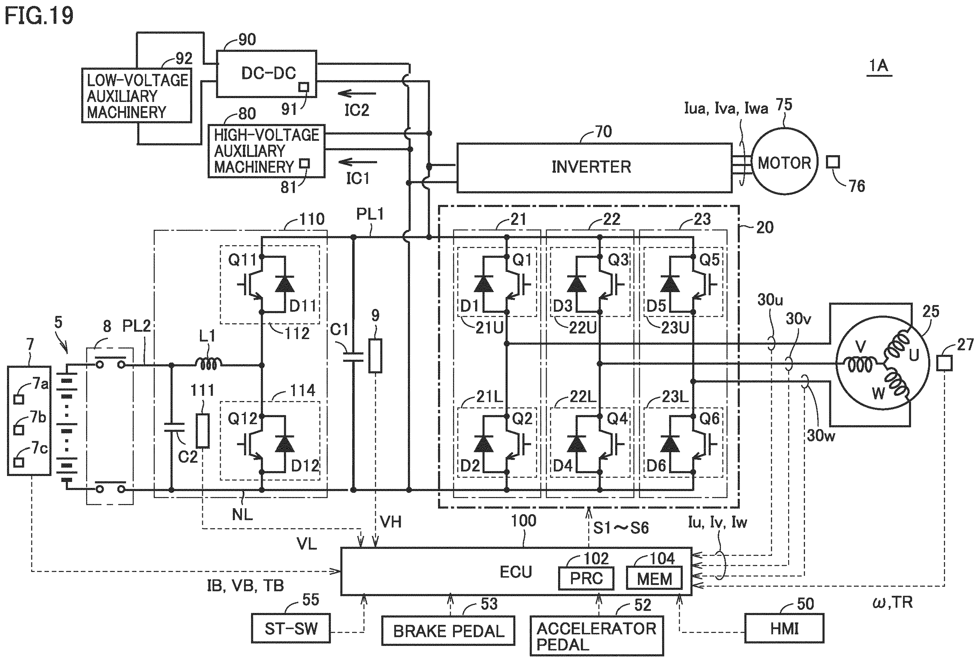

Fig. 19 is a diagram of an overall configuration of a vehicle on which an estimation system according to this modification is mounted. Referring to Fig. 19, a vehicle 1A is different from vehicle 1 in further including a boost chopper circuit 110.

Boost chopper circuit 110 is connected between battery 5 and inverter 20. Boost chopper circuit 110 receives an output voltage from battery 5 as a voltage VL (which will be described later) and up-converts the output voltage. The up-converted voltage is given as an input voltage (voltage VH) to inverter 20. Boost chopper circuit 110 is an exemplary constituent element of the "estimation system" in the present disclosure.

Boost chopper circuit 110 includes a reactor L1, a capacitor C2, a voltage sensor 111, an upper arm circuit 112, and a lower arm circuit 114.

Reactor L1 is connected to a positive electrode line PL2. Capacitor C2 is connected between positive electrode line PL2 and negative electrode line NL. Voltage sensor 111 detects voltage VL across positive electrode line PL2 and negative electrode line NL.

Upper arm circuit 112 includes a switching element Q11 and a diode D11. Diode D11 is connected in anti-parallel to switching element Q11. Lower arm circuit 114 includes a switching element Q12 and a diode D12. Diode D12 is connected in anti-parallel to switching element Q12.

ECU 100 controls on and off of switching element Q11 and switching element Q12. ECU 100 is configured to be capable of upper arm on control to maintain a conducting state of upper arm circuit 112 and a non-conducting state of lower arm circuit 114. Upper arm on control corresponds to maintaining switching elements Q11 to Q12 at on and off, respectively. ECU 100 carries out upper arm on control, for example, when a difference between voltage VH and voltage VL is smaller than a prescribed value (voltage VL is close to voltage VH). According to upper arm on control, power loss in switching elements Q11 and Q12 can be reduced and voltage fluctuation due to dead time can be prevented.

ECU 100 is configured to perform the first processing and the second processing described previously when it is carrying out upper arm on control and when a load of motor 25 is constant. ECU 100 can determine whether or not the load of motor 25 is constant based on torque TR.

Since the load of motor 25 is constant, the current (input and output current to and from inverter 20) in loop circuit CLA, CLB, CLC, CLD, CLE, or CLF is not affected by fluctuation in induced electromotive force of reactor L1. Consequently, the battery current value can accurately be estimated in this modification as in the embodiment.

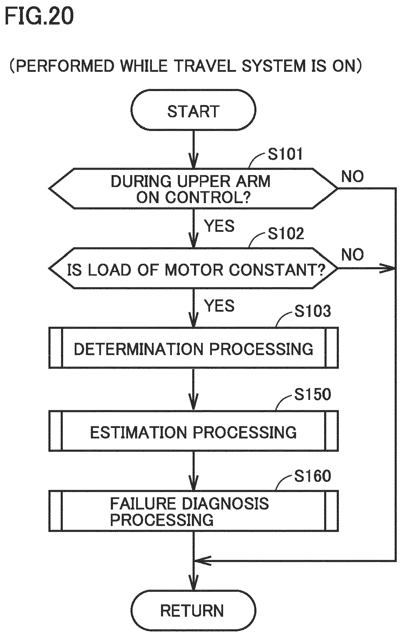

Fig. 20 is a flowchart illustrating an exemplary procedure of processing performed by ECU 100 in this modification. Referring to Fig. 20, this flowchart is different from the flowchart in Fig. 16 in addition of S101 and S102, whereas it is otherwise the same as the flowchart in Fig. 16.

ECU 100 switches processing in accordance with whether or not it is carrying out upper arm on control (for example, the difference between voltage VH and voltage VL is smaller than the prescribed value). When ECU 100 is not carrying out upper arm on control (NO in S101), the process makes transition to return. When ECU 100 is carrying out upper arm on control (YES in S101), the process proceeds to S102.

ECU 100 determines whether or not the load of motor 25 is constant in accordance with torque TR (S102). When the load of motor 25 is not constant (NO in S102), the process makes transition to return. When the load of motor 25 is constant (YES in S102), the process proceeds to S103. In the flowchart in Fig. 20, S103 may be skipped. In this case, ECU 100 performs S150 after S102.

According to this modification, even when inverter 20 is activated by receiving the voltage up-converted by boost chopper circuit 110, the battery current value can accurately be estimated.

[Other Modifications]

Vehicle 1 may include, separately from ECU 100, a peak detection circuit (not shown) that detects each peak value. The peak detection circuit provides the peak value it detects to ECU 100.

Vehicle 1 does not have to include current sensor 30w. In this case, ECU 100 estimates current Iw in accordance with detection values (currents Iu and Iv) from current sensors 30u and 30v. Specifically, ECU 100 performs, for example, only the first processing and the second processing among the first processing to the third processing described previously (estimates the battery current value only at time ta, time tb, time tp, and time tr).

Vehicle 1 may be an electrically powered vehicle such as a hybrid electric vehicle (HEV), a plug-in hybrid electric vehicle (PHEV), or a fuel cell electric vehicle (FCEV).

Vehicle 1 does not have to include inverter 70 and motor 75. In this case, vehicle 1 is a two-wheel drive electrically powered vehicle.

Though an embodiment of the present disclosure has been described, it should be understood that the embodiment disclosed herein is illustrative and non-restrictive in every respect. The scope of the present disclosure is defined by the terms of the claims and is intended to include any modifications within the scope of the claims.

**Claims**

1. An estimation system comprising:

   a power storage device (5);
   a first three-phase inverter (20) connected to the power storage device, the first three-phase inverter including a first leg circuit (21u), a second leg circuit (21v), and a third leg circuit (21w);
   a first three-phase AC motor (25) connected to the first three-phase inverter,

      each of the first leg circuit, the second leg circuit, and the third leg circuit including an upper arm circuit (22) and a lower arm circuit (23) that is turned on and off in a manner complementary to the upper arm circuit,

a mode of the first three-phase inverter including a first mode in which the upper arm circuit (22u) of the first leg circuit, the lower arm circuit (23v) of the second leg circuit, and the lower arm circuit (23w) of the third leg circuit are on and a second mode in which the lower arm circuit (23u) of the first leg circuit, the upper arm circuit (22v) of the second leg circuit, and the upper arm circuit (22w) of the third leg circuit are on;

a first current sensor (30u) that detects an AC current that flows between a first-phase coil (LU) of the first three-phase AC motor and the first leg circuit; and
a processing device (100) that performs estimation processing for estimating a current value of the power storage device, wherein
the estimation processing includes first processing for estimating the current value in accordance with a detection value from the first current sensor when the mode of the first three-phase inverter is set to the first mode or the second mode.

2. The estimation system according to claim 1, wherein
the first processing includes processing for estimating the current value in accordance with a peak value of the detection value from the first current sensor.

3. The estimation system according to claim 2, further comprising a second current sensor (30v) that detects an AC current that flows between a second-phase coil (LV) of the first three-phase AC motor and the second leg circuit, wherein

the mode of the first three-phase inverter includes a third mode in which the lower arm circuit (23u) of the first leg circuit, the upper arm circuit (22v) of the second leg circuit, and the lower arm circuit (23w) of the third leg circuit are on and a fourth mode in which the upper arm circuit (22u) of the first leg circuit, the lower arm circuit (23v) of the second leg circuit, and the upper arm circuit (22w) of the third leg circuit are on, and
the estimation processing further includes second processing for estimating the current value in accordance with a detection value from the second current sensor when the mode of the first three-phase inverter is set to the third mode or the fourth mode.

4. The estimation system according to claim 3, wherein
the second processing includes processing for estimating the current value in accordance with a peak value of the detection value from the second current sensor after the first current sensor detects the peak value.

5. The estimation system according to claim 1, further comprising at least one electrical apparatus (70, 80, 90) each configured to be activated by receiving electric power from the power storage device, wherein
the processing device performs the first processing while the at least one electrical apparatus is inactive.

6. The estimation system according to claim 5, wherein
the at least one electrical apparatus includes

auxiliary machinery (80) configured to be activated at an output voltage from the power storage device,
a power converter (90) configured to lower the output voltage, and
a second three-phase inverter (70) connected in parallel to the first three-phase inverter with respect to the power storage device.

7. The estimation system according to claim 1, further comprising a boost chopper circuit (110) connected between the power storage device and the first three-phase inverter, wherein

the boost chopper circuit includes an upper arm circuit (112) and a lower arm circuit (114), and
the processing device performs the first processing while a conducting state of the upper arm circuit of the boost chopper circuit and a non-conducting state of the lower arm circuit of the boost chopper circuit are maintained and a load of the first three-phase AC motor is constant.

8. The estimation system according to any one of claims 1 to 7, further comprising a current detector (7a) that detects the current value of the power storage device, wherein
the processing device is configured to further perform failure diagnosis processing for diagnosing whether the current detector has failed based on comparison between the detection value from the first current sensor and a detection value from the current detector.

**Patentansprüche**

1. Schätzsystem, das Folgendes umfasst:

   eine Energiespeichervorrichtung (5);
   einen ersten Dreiphasenwechselrichter (20), der mit der Energiespeichervorrichtung verbunden ist, wobei der erste Dreiphasenwechselrichter eine erste Zweigschaltung (21u), eine zweite Zweigschaltung (21v) und eine dritte Zweigschaltung (21w) enthält;
   einen ersten Dreiphasen-Wechselstrommotor (25), der mit dem ersten Dreiphasenwechselrichter verbunden ist, wobei jede der ersten Zweigschaltung, der zweiten Zweigschaltung und der dritten Zweigschaltung eine obere Armschaltung (22) und eine untere Armschaltung (23), die komplementär zu der oberen Armschaltung ein- und ausgeschaltet wird, enthält,
   ein Modus des ersten Dreiphasenwechselrichters einen ersten Modus, in dem die obere Armschaltung (22u) der ersten Zweigschaltung, die untere Armschaltung (23v) der zweiten Zweigschaltung und die untere Armschaltung (23w) der dritten Zweigschaltung eingeschaltet sind, und einen zweiten Modus, in dem die untere Armschaltung (23u) der ersten Zweigschaltung, die obere Armschaltung (22v) der zweiten Zweigschaltung und die obere Armschaltung (22w) der dritten Zweigschaltung eingeschaltet sind, enthält;
   einen ersten Stromsensor (30u), der einen Wechselstrom detektiert, der zwischen einer Spule (LU) der ersten Phase des ersten Dreiphasen-Wechselstrommotors und der ersten Zweigschaltung fließt; und
   eine Verarbeitungsvorrichtung (100), die eine Schätzverarbeitung zum Schätzen eines Stromwerts der Energiespeichervorrichtung durchführt, wobei
   die Schätzverarbeitung eine erste Verarbeitung zum Schätzen des Stromwertes in Übereinstimmung mit einem Detektionswert von dem ersten Stromsensor enthält, wenn der Modus des ersten Dreiphasenwechselrichters in dem ersten Modus oder dem zweiten Modus eingestellt ist.

2. Schätzsystem nach Anspruch 1, wobei
   die erste Verarbeitung die Verarbeitung zum Schätzen des Stromwertes in Übereinstimmung mit einem Spitzenwert des Detektionswerts von dem ersten Stromsensor enthält.

3. Schätzsystem nach Anspruch 2, das ferner einen zweiten Stromsensor (30v) umfasst, der einen Wechselstrom detektiert, der zwischen einer Spule (LV) der zweiten Phase des ersten Dreiphasen-Wechselstrommotors und der zweiten Zweigschaltung fließt, wobei

   der Modus des ersten Dreiphasenwechselrichters einen dritten Modus, in dem die untere Armschaltung (23u) der ersten Zweigschaltung, die obere Armschaltung (22v) der zweiten Zweigschaltung und die untere Armschaltung (23w) der dritten Zweigschaltung eingeschaltet sind, und einen vierten Modus, in dem die obere Armschaltung (22u) der ersten Zweigschaltung, die untere Armschaltung (23v) der zweiten Zweigschaltung und die obere Armschaltung (22w) der dritten Zweigschaltung eingeschaltet sind, enthält, und
   die Schätzverarbeitung ferner eine zweite Verarbeitung zum Schätzen des Stromwertes in Übereinstimmung mit einem Detektionswert von dem zweiten Stromsensor, wenn der Modus des ersten Dreiphasenwechselrichters in dem dritten Modus oder dem vierten Modus eingestellt ist, enthält.

4. Schätzsystem nach Anspruch 3, wobei
   die zweite Verarbeitung die Verarbeitung zum Schätzen des Stromwerts in Übereinstimmung mit einem Spitzenwert des Detektionswerts von dem zweiten Stromsensor, nachdem der erste Stromsensor den Spitzenwert detektiert hat, enthält.

5. Schätzsystem nach Anspruch 1, das ferner mindestens eine elektrische Vorrichtung (70, 80, 90) umfasst, die jeweils konfiguriert sind, durch das Empfangen von elektrischer Energie von der Energiespeichervorrichtung aktiviert zu werden, wobei
   die Verarbeitungsvorrichtung die erste Verarbeitung durchführt, während mindestens eine elektrische Vorrichtung inaktiv ist.

6. Schätzsystem nach Anspruch 5, wobei
   die mindestens eine elektrische Vorrichtung Folgendes enthält:

   Hilfsmaschinerie (80), die konfiguriert ist, bei einer Ausgangsspannung von der Energiespeichervorrichtung aktiviert zu werden,

einen Leistungsumsetzer (90), der konfiguriert ist, die Ausgangsspannung zu verringern, und

einen zweiten Dreiphasenwechselrichter (70), der bezüglich der Energiespeichervorrichtung zu dem ersten Dreiphasenwechselrichter parallelgeschaltet ist.

7.  Schätzsystem nach Anspruch 1, das ferner eine Boost-Zerhackerschaltung (110) umfasst, die zwischen der Energiespeichervorrichtung und dem ersten Dreiphasenwechselrichter geschaltet ist, wobei

die Boost-Zerhackerschaltung eine obere Armschaltung (112) und eine untere Armschaltung (114) umfasst, und die Verarbeitungsvorrichtung die erste Verarbeitung durchführt, während ein leitender Zustand der oberen Armschaltung der Boost-Zerhackerschaltung und ein nicht leitender Zustand der unteren Armschaltung der Boost-Zerhackerschaltung beibehalten werden und eine Last des ersten Dreiphasen-Wechselstrommotors konstant ist.

8.  Schätzsystem nach einem der Ansprüche 1 bis 7, das ferner einen Stromdetektor (7a) umfasst, der den Stromwert der Energiespeichervorrichtung detektiert,
wobei
die Verarbeitungsvorrichtung konfiguriert ist, ferner eine Fehlerdiagnose-Verarbeitung durchzuführen, um basierend auf einem Vergleich zwischen dem Detektionswert von dem ersten Stromsensor und einem Detektionswert von dem Stromdetektor zu diagnostizieren, ob der Stromdetektor ausgefallen ist.

**Revendications**

1.  Système d'estimation comprenant :

un dispositif de stockage de puissance (5) ;
un premier onduleur triphasé (20) connecté au dispositif de stockage d'énergie, le premier onduleur triphasé comprenant un premier circuit de branche (21u), un deuxième circuit de branche (21v) et un troisième circuit de branche (21w) ;
un premier moteur triphasé à courant alternatif (25) connecté au premier onduleur triphasé,
chacun du premier circuit de branche, du deuxième circuit de branche et du troisième circuit de branche comprenant un circuit de bras supérieur (22) et un circuit de bras inférieur (23) qui est activé et désactivé de manière complémentaire par rapport au circuit de bras supérieur, un mode du premier onduleur triphasé comprenant un premier mode dans lequel le circuit de bras supérieur (22u) du premier circuit de branche, le circuit de bras inférieur (23v) du deuxième circuit de branche et le circuit de bras inférieur (23w) du troisième circuit de branche sont activés, et un deuxième mode dans lequel le circuit de bras inférieur (23u) du premier circuit de branche, le circuit de bras supérieur (22v) du deuxième circuit de branche et le circuit de bras supérieur (22w) du troisième circuit de branche sont activés ;
un premier capteur de courant (30u) qui détecte un courant alternatif qui circule entre une première bobine de phase (LU) du premier moteur triphasé à courant alternatif et le premier circuit de branche ; et
un dispositif de traitement (100) qui effectue un traitement d'estimation pour estimer une valeur de courant du dispositif de stockage d'énergie, où
le traitement d'estimation comprend un premier traitement pour estimer la valeur du courant en fonction d'une valeur de détection provenant du premier capteur de courant lorsque le mode du premier onduleur triphasé est réglé sur le premier mode ou le deuxième mode.

2.  Système d'estimation selon la revendication 1, dans lequel
le premier traitement comprend un traitement pour estimer la valeur du courant en fonction d'une valeur de crête de la valeur de détection provenant du premier capteur de courant.

3.  Système d'estimation selon la revendication 2, comprenant en outre un deuxième capteur de courant (30v) qui détecte un courant alternatif qui circule entre une deuxième bobine de phase (LV) du premier moteur triphasé à courant alternatif et le deuxième circuit de branche, où

le mode du premier onduleur triphasé comprend un troisième mode dans lequel le circuit de bras inférieur (23u) du premier circuit de branche, le circuit de bras supérieur (22v) du deuxième circuit de branche et le circuit de bras inférieur (23w) du troisième circuit de branche sont activés, et un quatrième mode dans lequel le circuit de bras supérieur (22u) du premier circuit de branche, le circuit de bras inférieur (23v) du deuxième circuit de branche et le circuit de bras supérieur (22w) du troisième circuit de branche sont activés, et

le traitement d'estimation comprend en outre un deuxième traitement pour estimer la valeur de courant en fonction d'une valeur de détection provenant du deuxième capteur de courant lorsque le mode du premier onduleur triphasé est réglé sur le troisième mode ou le quatrième mode.

4. Système d'estimation selon la revendication 3, dans lequel

le deuxième traitement comprend un traitement pour estimer la valeur de courant en fonction d'une valeur de crête de la valeur de détection provenant du deuxième capteur de courant après que le premier capteur de courant a détecté la valeur de crête.

5. Système d'estimation selon la revendication 1, comprenant en outre au moins un appareil électrique (70, 80, 90) configuré pour être activé en recevant de l'énergie électrique en provenance du dispositif de stockage d'énergie, où le dispositif de traitement effectue le premier traitement pendant que l'au moins un appareil électrique est inactif.

6. Système d'estimation selon la revendication 5, dans lequel

l'au moins un appareil électrique comprend un mécanisme auxiliaire (80) configuré pour être activé à une tension de sortie provenant du dispositif de stockage d'énergie,

un convertisseur de puissance (90) configuré pour abaisser la tension de sortie, et

un deuxième onduleur triphasé (70) connecté en parallèle au premier onduleur triphasé par rapport au dispositif de stockage d'énergie.

7. Système d'estimation selon la revendication 1, comprenant en outre un circuit hacheur élévateur (110) connecté entre le dispositif de stockage d'énergie et le premier onduleur triphasé, où

le circuit hacheur élévateur comprend un circuit de bras supérieur (112) et un circuit de bras inférieur (114), et

le dispositif de traitement effectue le premier traitement tandis qu'un état conducteur du circuit de bras supérieur du circuit hacheur élévateur et un état non conducteur du circuit de bras inférieur du circuit hacheur élévateur sont maintenus et qu'une charge du premier moteur triphasé à courant alternatif est constante.

8. Système d'estimation selon l'une quelconque des revendications 1 à 7, comprenant en outre un détecteur de courant (7a) qui détecte la valeur de courant du dispositif de stockage d'énergie, où

le dispositif de traitement est configuré pour effectuer en outre un traitement de diagnostic de défaillance afin de diagnostiquer si le détecteur de courant est défaillant sur la base d'une comparaison entre la valeur de détection provenant du premier capteur de courant et une valeur de détection provenant du détecteur de courant.

EP 4 421 500 B1

FIG.1

FIG.2

$$( Iv = Iu + Iw )$$

MODE A

FIG.3

$$( Iu = Iv + Iw )$$

MODE B

FIG.4

( Iw = Iu + Iv )

MODE C

FIG.5

( Iv = Iu + Iw )

MODE D

FIG.6

MODE E

$( \, Iu = Iv + Iw \, )$

FIG.7

MODE F

$( \, Iw = Iu + Iv \, )$

## FIG.8

| | | MODE | | | | | |
|---|---|---|---|---|---|---|---|
| | | A | B | C | D | E | F |
| SWITCHING PATTERN | Q1 | ON | ON | ON | | | |
| | Q2 | | | | ON | ON | ON |
| | Q3 | | | ON | ON | ON | |
| | Q4 | ON | ON | | | | ON |
| | Q5 | ON | | | | ON | ON |
| | Q6 | | ON | ON | ON | | |
| VARIATION IN CURRENT | | | | | | | |

# FIG.9

ERROR [A]

(+)

415

405

EW2

EW1

DETECTED
CURRENT [A]

(−)

0

(+)

405

415

(−)

EW2 = n × EW1

( ex. n = 2 )

# FIG.10

Iu, Iv, Iw, IB

( 210 : 30u )
( 220 : 30v )
( 230 : 30w )

300

210

220

230

Iup+
(ESV)

Ivp+
(ESV)

Iwp+
(ESV)

(+)

tp

tq

tr

t

0

ta

tb

tc

(−)

Ivp−
(ESV)

Iwp−
(ESV)

Iup−
(ESV)

A     B     C     D     E     F

(MODE)

# FIG.11

500

| | | MODE | | | | | |
|---|---|---|---|---|---|---|---|
| | | A | B | C | D | E | F |
| SWITCHING PATTERN | Q1 | ON | ON | ON | | | |
| | Q2 | | | | ON | ON | ON |
| | Q3 | | | ON | ON | ON | |
| | Q4 | ON | ON | | | | ON |
| | Q5 | ON | | | | ON | ON |
| | Q6 | | ON | ON | ON | | |
| SUBJECT SENSOR | | 30v | 30u | 30w | 30v | 30u | 30w |

# FIG.12

(ex. EW2 = 2 × EW1)

# FIG.13

(PERFORMED WHILE TRAVEL SYSTEM IS ON)

```
         ( START )
             │
             ▼         ┌─ S150
   ┌─────────────────────────┐
   ║  ESTIMATION PROCESSING  ║
   └─────────────────────────┘
             │
             ▼         ┌─ S160
   ┌─────────────────────────┐
   ║  FAILURE DIAGNOSIS      ║
   ║  PROCESSING            ║
   └─────────────────────────┘
             │
             ▼
         ( RETURN )
```

# FIG.14

```
   ┌─────────────────┐
   ║  ESTIMATION     ║
   ║  PROCESSING     ║
   └─────────────────┘
             │      ┌─ S152
             ▼
   <  MODE OF INVERTER? >──────────────────────────────────┐
        │            │                    │                │
     MODE A        MODE B              MODE C              │
        │   ┌S153     │   ┌S154           │   ┌S155         │
        ▼             ▼                    ▼                │
 ┌──────────────┐ ┌──────────────┐ ┌──────────────┐        │
 │ESTIMATE      │ │ESTIMATE      │ │ESTIMATE      │        │
 │BATTERY       │ │BATTERY       │ │BATTERY       │        │
 │CURRENT VALUE │ │CURRENT VALUE │ │CURRENT VALUE │        │
 │IN ACCORDANCE │ │IN ACCORDANCE │ │IN ACCORDANCE │        │
 │WITH PEAK     │ │WITH PEAK     │ │WITH PEAK     │        │
 │VALUE Ivp−    │ │VALUE Iup+    │ │VALUE Iwp−    │        │
 └──────────────┘ └──────────────┘ └──────────────┘        │
        │◄───────────────┘──────────────────┘              │
        ▼                                                   │
    TO S160                                                 │
                                                            │
        ┌───────────────────────────────────────────────────┘
        │                    │                    │
     MODE D              MODE E              MODE F
        │   ┌S156           │   ┌S157           │   ┌S158
        ▼                    ▼                    ▼
 ┌──────────────┐ ┌──────────────┐ ┌──────────────┐
 │ESTIMATE      │ │ESTIMATE      │ │ESTIMATE      │
 │BATTERY       │ │BATTERY       │ │BATTERY       │
 │CURRENT VALUE │ │CURRENT VALUE │ │CURRENT VALUE │
 │IN ACCORDANCE │ │IN ACCORDANCE │ │IN ACCORDANCE │
 │WITH PEAK     │ │WITH PEAK     │ │WITH PEAK     │
 │VALUE Ivp+    │ │VALUE Iup−    │ │VALUE Iwp+    │
 └──────────────┘ └──────────────┘ └──────────────┘
        │◄───────────────┘──────────────────┘
        ▼
    TO S160
```

## FIG.15

```
┌─────────────────────────┐
│  FAILURE DIAGNOSIS      │
│  PROCESSING             │
└─────────────────────────┘
            │
            ▼            ⌐S162
┌─────────────────────────┐
│  OBTAIN DETECTION VALUE │
│  OF CURRENT IB          │
└─────────────────────────┘
            │
            ▼            ⌐S164
      IS DIFFERENCE Diff BETWEEN        NO
      ESTIMATED VALUE ESV AND      ────────────┐
      DETECTION VALUE SMALLER                  │
      THAN REFERENCE VALUE?                    │
            │                                  │
            │ YES        ⌐S166                 ▼            ⌐S168
┌─────────────────────────┐     ┌─────────────────────────┐
│  DIAGNOSIS THAT CURRENT │     │  DIAGNOSIS THAT CURRENT │
│  SENSOR IS NORMAL       │     │  SENSOR MAY HAVE FAILED │
└─────────────────────────┘     └─────────────────────────┘
            │                                  │
            ▼◄─────────────────────────────────┘
```

TRANSITION TO "RETURN"

## FIG.16

(PERFORMED WHILE TRAVEL SYSTEM IS ON)

```
        ┌──────────┐
        │  START   │
        └──────────┘
             │
             ▼              ⌐S103
     ┌───────────────────────────┐
     │  DETERMINATION PROCESSING │
     └───────────────────────────┘
             │
             ▼              ⌐S150
     ┌───────────────────────────┐
     │  ESTIMATION PROCESSING    │
     └───────────────────────────┘
             │
             ▼              ⌐S160
     ┌───────────────────────────┐
     │  FAILURE DIAGNOSIS        │
     │  PROCESSING               │
     └───────────────────────────┘
             │
             ▼
        ┌──────────┐
        │  RETURN  │
        └──────────┘
```

## FIG.17

```
┌─────────────────────────────────┐
│║ DETERMINATION PROCESSING      ║│
└─────────────────────────────────┘
              │
              ▼      ╭─ S104
    ╱─────────────────────╲          NO
   ⟨  IS AT LEAST ONE ELECTRICAL  ⟩────────────┐
   ⟨   APPARATUS INACTIVE?        ⟩            │
    ╲─────────────────────╱                    │
              │                                │
              ▼ YES                            ▼
          TO S150                「TRANSITION TO "RETURN"
```

## FIG.18

```
┌─────────────────────────────────┐
│║ DETERMINATION PROCESSING      ║│
└─────────────────────────────────┘
              │
              ▼      ╭─ S105
    ╱─────────────────────╲          NO
   ⟨   IS INVERTER 70 INACTIVE?  ⟩────────────┐
    ╲─────────────────────╱                    │
              │                                ▼
              ▼ YES                  TRANSITION TO "RETURN"
              │      ╭─ S110
    ╱─────────────────────╲          NO
   ⟨  IS HIGH-VOLTAGE AUXILIARY  ⟩────────────┐
   ⟨   MACHINERY INACTIVE?       ⟩            │
    ╲─────────────────────╱                    ▼
              │                      TRANSITION TO "RETURN"
              ▼ YES
              │      ╭─ S120
    ╱─────────────────────╲          NO
   ⟨ IS DC-DC CONVERTER INACTIVE? ⟩────────────┐
    ╲─────────────────────╱                    │
              │                                ▼
              ▼ YES                  TRANSITION TO "RETURN"
          TO S150
```

FIG.19

FIG.20

(PERFORMED WHILE TRAVEL SYSTEM IS ON)

START

S101

DURING UPPER ARM
ON CONTROL? — NO

YES

S102

IS LOAD OF MOTOR CONSTANT? — NO

YES

S103

DETERMINATION PROCESSING

S150

ESTIMATION PROCESSING

S160

FAILURE DIAGNOSIS
PROCESSING

RETURN

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023025017 A
- JP 2006020401 A